# EUROPEAN PATENT APPLICATION

(11) **EP 4 729 144 A1**
(43) Date of publication of application: **22.04.2026**
(21) Application number: 24822699.5
(22) Date of filing: 12.06.2024
(51) Int. Cl.: B01D 19/00, H01L 21/67

(54) **LIQUID DEFOAMING DEVICE AND CLEANING APPARATUS**

(30) Priority: 13.06.2023 CN 202310700857
(71) Applicant: Beijing NAURA Microelectronics Equipment Co., Ltd., Beijing 100176 (CN)
(72) Inventor: LIU, Xiaohuan, Beijing 100176 (CN); DONG, Lirong, Beijing 100176 (CN); ZHANG, Yutao, Beijing 100176 (CN); XU, Yao, Beijing 100176 (CN); ZHENG, Shijie, Beijing 100176 (CN); ZHANG, Huwei, Beijing 100176 (CN); ZHAO, Hongyu, Beijing 100176 (CN); WANG, Ruiting, Beijing 100176 (CN); FU, Gang, Beijing 100176 (CN)
(74) Representative: LifeTech IP Spies & Behrndt Patentanwälte PartG mbB
(86) International application number: PCT/CN2024/098580
(87) International publication number: WO 2024/255750

(57) **Abstract**

The present disclosure provides a liquid defoaming device and a cleaning apparatus, relates to the field of semiconductor processing technology, and aims to solve a problem that a large amount of foam is mixed in a liquid in a tested pipeline. The liquid defoaming device includes: a defoaming chamber, an inner wall surface of the defoaming chamber being a rotating curved surface, a radius of an inner-wall-surface lower part gradually decreasing from top to bottom, the defoaming chamber being provided with a liquid inlet and a first drain port, the liquid inlet being disposed in an upper part of the defoaming chamber, a liquid inlet direction of the liquid inlet being parallel with a tangential direction of an inner-wall-surface upper part of the defoaming chamber, and the first drain port being located in the middle of a bottom end of the inner wall surface; and a cover, the cover being disposed on the defoaming chamber and provided with a second drain port, and the second drain port being disposed opposite to a center of a top end of the defoaming chamber. The liquid defoaming device provided in the present disclosure can improve separation efficiency and reduce a foam content in the liquid.

## Description

### TECHNICAL FIELD

The present disclosure relates to the field of semiconductor processing technology, and in particular, to a liquid defoaming device and a cleaning apparatus.

### BACKGROUND

A wet-etching tank-type cleaning apparatus in the semiconductor industry is generally formed from modules with different process functions, such as Standard Chemical 1 (SC1), Standard Chemical 2 (SC2), Buffered Oxide Etch (BOE), and Sulfuric Acid/Hydrogen Peroxide Module (SPM). Each of the modules includes one or more main chemical solution circulation pipelines, and each circulation pipeline mainly include a process tank, a circulation pump, a filter, a heater, a flowmeter, and a concentration meter.

Since hydrogen peroxide (H₂O₂) is usually added to the circulation pipelines during a cleaning process for enhancing a cleaning effect, a large amount of foam is generated in the pipelines, especially in the circulation pipeline of the SPM, such that flow measurement by the flowmeter is inaccurate or the concentration meter cannot display an actual detected concentration value accurately. Further, the pump generally used in chemical cleaning is a diaphragm pump, so that the chemical solution flows in the circulation lines in a pulsed manner, which results in unstable flow rates in the pipelines and also causes difficulty in flow detection or concentration detection.

### SUMMARY

The first objective of the present disclosure is to provide a liquid defoaming device for solving a problem in the prior art that a large amount of foam is mixed in a liquid in a tested pipeline.

A liquid defoaming device provided in the present disclosure is applied to a semiconductor cleaning apparatus and includes:
a defoaming chamber, an inner wall surface of the defoaming chamber being a rotating curved surface, and a radius of an inner-wall-surface lower part gradually decreasing from top to bottom; the defoaming chamber being provided with a liquid inlet and a first drain port, the liquid inlet being disposed in an upper part of the defoaming chamber, a liquid inlet direction of the liquid inlet being parallel with a tangential direction of an inner-wall-surface upper part of the defoaming chamber, and the first drain port being located in the middle of a bottom end of the inner wall surface; and
a cover, the cover being disposed on the defoaming chamber and provided with a second drain port, and the second drain port being disposed opposite to a center of a top end of the defoaming chamber.

In some technical solutions, the liquid defoaming device further includes a guide member, which is disposed opposite to the liquid inlet, wherein a first surface of the guide member facing the liquid inlet gradually descends along a direction in which a mixed solution entering from the liquid inlet flows on the first surface, and the first surface is configured to increase a downward flow velocity of the mixed solution.

In some technical solutions, an acute angle between the first surface and a horizontal direction gradually increases along the direction in which the mixed solution flows on the first surface.

In some technical solutions, the guide member is a rotary impeller, and the rotary impeller performs a circumferential motion relative to the cover and is axially fixed to the cover.

In some technical solutions, the cover includes:
a cover body; and
an impeller mounting part, which is fixedly connected to a surface of the cover body facing an interior of the defoaming chamber; and an impeller fixing member being fixedly connected to a bottom of the impeller mounting part and configured to axially fix the rotary impeller.

In some technical solutions, the impeller mounting part is provided with a sleeve part, a bottom of the sleeve part is provided an internal thread, the impeller fixing member is provided with an external thread, and the impeller fixing member is fixedly connected to the sleeve part through the external thread and the internal thread matched with each other.

In some technical solutions, the liquid defoaming device further includes:
a drain pipe, which is located at a top of a space inside the defoaming chamber and communicated with the second drain port, and has a top provided with radial through holes penetrating through the drain pipe along a thickness direction of the drain pipe.

In some technical solutions, the inner-wall-surface upper part of the defoaming chamber is a cylindrical surface.

The second objective of the present disclosure is to provide a cleaning apparatus for solving the problem that a large amount of foam is mixed in the liquid in the tested pipeline.

A cleaning apparatus provided in the present disclosure includes a circulation pump, a heater, a filter, and the above liquid defoaming device, which are sequentially communicated.

In some technical solutions, the cleaning apparatus further includes a process tank, the process tank includes an inner tank and an outer tank outside the inner tank, an inlet of the circulation pump is communicated with an outlet of the outer tank, an outlet of the filter is communicated with the liquid inlet of the liquid defoaming device, the first drain port of the liquid defoaming device is communicated with an inlet of the inner tank through a flowmeter, and the second drain port of the liquid defoaming device is communicated with an inlet of the outer tank through a throttling element.

In some technical solutions, the cleaning apparatus further includes a process tank, the process tank includes an inner tank and an outer tank outside the inner tank, an inlet of the circulation pump is communicated with an outlet of the outer tank, an outlet of the filter is communicated with the liquid inlet of the liquid defoaming device and an inlet of a flowmeter, an outlet of the flowmeter is communicated with an inlet of the inner tank, the first drain port of the liquid defoaming device is communicated with an inlet of the outer tank through a concentration meter, and the second drain port of the liquid defoaming device is communicated with the inlet of the outer tank through a throttling element.

In some technical solutions, the throttling element includes a throttling cavity, a bottom of an inner wall surface of the throttling cavity is a hemispherical surface, and a throttle hole is provided at a bottom of the throttling cavity.

In some technical solutions, the throttling element is a needle valve or a capillary tube.

The liquid defoaming device and the cleaning apparatus provided in the present disclosure can produce the following beneficial effects.

For the liquid defoaming device provided in the present disclosure, by disposing the liquid inlet in the upper part of the defoaming chamber along the direction parallel with the tangential direction of the inner-wall-surface upper part, when the mixed solution flows into the upper part of the defoaming chamber from the liquid inlet, the mixed solution performs a circumferential motion along the inner-wall-surface upper part instead of a linear motion along the direction parallel with the tangential direction of the inner-wall-surface upper part, the mixed solution is thrown to the inner wall surface of the defoaming chamber under the action of centrifugal force, and the mixed solution can spirally move towards the inner-wall-surface lower part along the inner-wall-surface upper part once in contact with the inner wall surface. Since a density of the liquid in the mixed solution is much greater than that of the foam in the mixed solution, the liquid is more likely to concentrate towards the inner wall surface than the foam during the spiral movement, that is, a larger proportion of the liquid is thrown towards the inner wall surface, while the foam is relatively away from the inner wall surface.

When the mixed solution enters the inner-wall-surface lower part having the radius gradually decreasing from top to bottom, since the mixed solution does not flow on an absolute horizontal plane, the gravitational acceleration is converted into an increase of an actual tangential velocity with the aid of the shape of the inner-wall-surface lower part, and an inertial centrifugal force of the mixed solution is increased as a rotation radius gradually decreases, so that a tendency of the liquid in the mixed solution to move outwards becomes more obvious. Meanwhile, as the rotation radius gradually decreases, the mixed solution can also generate a velocity component towards a center of a bottom of the inner wall surface, and finally forms a centripetal radial liquid flow under the extrusion of an outward vortex at the bottom. In addition, during the movement, the foam can gradually float upwards due to the smaller density thereof. Due to continuous injection of the mixed solution from a position close to the inner wall surface, the foam can gradually converge upwards and towards a center of the defoaming chamber. Therefore, the liquid falling to a bottom of the defoaming chamber contains almost no foam, and can be discharged through the first drain port in the middle of the bottom end. The mixed solution containing a large proportion of foam is prevented from being discharged from the first drain port under the action of the original tangential velocity, and still flows in a spiral manner. Meanwhile, the mixed solution containing a large proportion of foam is confined, from the outside, by the outward vortex flowing downwards along the inner wall surface, so that the mixed solution containing a large proportion of foam flows upwards in a spiral manner, and is discharged through the second drain port.

Thus, the liquid defoaming device can effectively separate the liquid having a high foam content in the mixed solution from the foam-free liquid in the mixed solution, and can achieve higher separation speed and higher separation efficiency compared with static gas-liquid separation or a method not adopting a chamber with a radius gradually decreasing from top to bottom.

### BRIEF DESCRIPTION OF DRAWINGS

In order to illustrate the technical solutions in the embodiments or the background part of the present disclosure more clearly, the drawings for the illustration of the embodiments or the background part will be briefly described below. Apparently, the drawings described below are just for the embodiments of the present disclosure, and other drawings can be derived by those of ordinary skill in the art from the drawings described below without any inventive work.
FIG. 1 is a schematic diagram of a cleaning apparatus according to the related art;
FIG. 2 is a schematic diagram of another cleaning apparatus according to the related art;
FIG. 3 is a schematic structural diagram of a liquid defoaming device according to Embodiment One of the present disclosure;
FIG. 4 is a cross-sectional view of the liquid defoaming device according to the Embodiment One of the present disclosure;
FIG. 5 is a schematic structural diagram of a defoaming chamber in the liquid defoaming device according to the Embodiment One of the present disclosure;
FIG. 6 is a left view of FIG. 5;
FIG. 7 is a top view of FIG. 5;
FIG. 8 is a schematic diagram illustrating flowing of a liquid in the liquid defoaming device according to the Embodiment One of the present disclosure;
FIG. 9 is another cross-sectional view of the liquid defoaming device according to the Embodiment One of the present disclosure;
FIG. 10 is a schematic structural diagram of a cover in the liquid defoaming device according to the Embodiment One of the present disclosure;
FIG. 11 is a schematic structural diagram of the cover in the liquid defoaming device according to the Embodiment One of the present disclosure from another view;
FIG. 12 is a schematic structural diagram of a cleaning apparatus according to an implementation of Embodiment Two of the present disclosure;
FIG. 13 is a schematic structural diagram of the cleaning apparatus according to another implementation of the Embodiment Two of the present disclosure;
FIG. 14 is a schematic structural diagram of a throttling element in the cleaning apparatus according to an implementation manner of the Embodiment Two of the present disclosure; and
FIG. 15 is a schematic structural diagram of the throttling element of FIG. 14 from another view.

### Description of reference numerals:

10-liquid inlet pipe; 20-male threaded connector; 30- gas-liquid liquid outlet pipe joint; 40-cover; 41-second drain port; 42-cover body; 43-impeller mounting part; 44-internal thread; 45-drain pipe; 46-radial through hole; 50-defoaming chamber; 51-inner-wall-surface upper part; 52-inner-wall-surface lower part; 53-liquid inlet; 54-first drain port; 60- liquid outlet joint; 70-rotary impeller; 80-impeller fixing member; 90-sealing ring;
110-process tank; 111-inner tank; 112-outer tank; 120-circulation pump; 130-heater; 140-filter; 150-flowmeter; 160-concentration meter; 170-throttling element; 171-throttling cavity; 172-throttle hole; 180-liquid defoaming device.

### DETAIL DESCRIPTION OF EMBODIMENTS

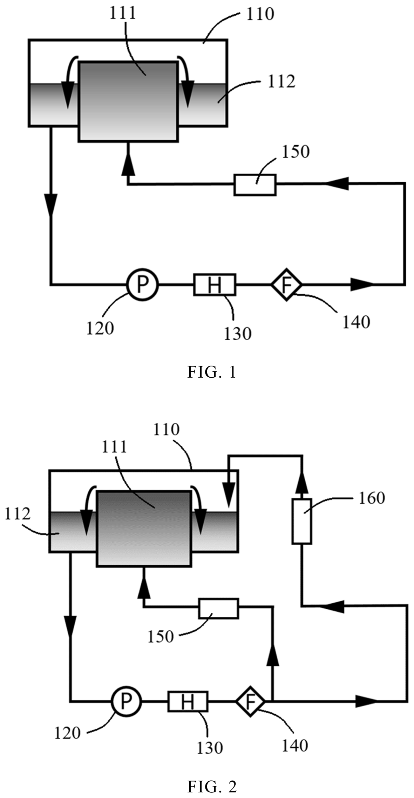

FIG. 1 shows devices in a circulation pipeline in a cleaning apparatus in the related art. A process tank 110 is divided into an inner tank 111 and an outer tank 112; a chemical solution enters a circulation pump 120 after flowing out of the outer tank 112, flows through a heater 130, a filter 140, and a flowmeter 150, flows into the inner tank 111, and then overflows from the inner tank 111 to the outer tank 112, thereby completing a cycle; and wafers are cleaned in the inner tank 111.

FIG. 2 shows devices in a circulation pipeline in a cleaning apparatus having a concentration detection function in the related art. The chemical solution enters the circulation pump 120 after flowing out of the outer tank 112, flows through the heater 130, the filter 140, and the flowmeter 150, flows into the inner tank 111, and then overflows from the inner tank 111 to the outer tank 112, thereby completing a cycle. Since the chemical solution needs to be maintained at room temperature when a concentration meter 160 is in operation, the concentration meter 160 cannot be disposed in the main circulation pipeline, a branch needs to be provided after the filter 140 to enable the chemical solution to enter the concentration meter 160, and the measured chemical solution directly flows back to the outer tank 112 of the process tank 110.

Since hydrogen peroxide (H₂O₂) is usually added to the circulation pipelines during a cleaning process for enhancing a cleaning effect, a large amount of foam is generated in the pipelines, especially in the circulation pipeline of the SPM, such that flow measurement by the flowmeter is inaccurate or the concentration meter cannot display an actual detected concentration value accurately. Further, the pump generally used in chemical cleaning is a diaphragm pump, so that the chemical solution flows in the circulation lines in a pulsed manner, which results in unstable flow rates in the pipelines and also causes difficulty in flow detection or concentration detection.

An existing liquid defoaming device includes: a degassing bucket, a liquid inlet, an exhaust port, a drain port, a control module, and a liquid level detection module. An inner cavity of the degassing bucket is configured to provide a space for separating liquid from foam; the liquid inlet is disposed in an upper part of the degassing bucket, and a liquid inlet valve is disposed at the liquid inlet; the exhaust port is disposed at a top of the degassing bucket, and an exhaust valve is disposed at the exhaust port; the drain port is disposed at a bottom of the degassing bucket, and a drain valve is disposed at the drain port; the liquid inlet valve, the exhaust valve, and the drain valve are all electrically connected to the control module and configured to execute corresponding actions under the control of the control module; and the liquid level detection module is electrically connected to the control module and configured to detect a liquid level in the degassing bucket and feed the liquid level back to the control module. A beneficial effect of the device is that under the control of the control module, the foam in the liquid is automatically separated from the liquid and the foam and the liquid are automatically discharged, thereby avoiding an adverse effect of the foam in the liquid on a subsequent reaction.

However, the device involves a plurality of electrically connected pneumatic valves, liquid level sensors, and control modules, and needs electrical control or software programming control, so that the device is complex in design and high in cost; moreover, although the device can automatically separate the foam in the liquid from the liquid, a sudden change of a flow rate inevitably causes instant turbulence to the flow of the liquid in the circulation pipelines when the pneumatic valves are opened or closed, which causes interference in the cleaning process.

In order to make the above objectives, features and advantages of the present disclosure more obvious and understandable, specific embodiments of the present disclosure are described in detail below with reference to the drawings. It should be understood that the specific embodiments described herein are only intended to explain the present disclosure, rather than limiting the present disclosure.

### Embodiment One

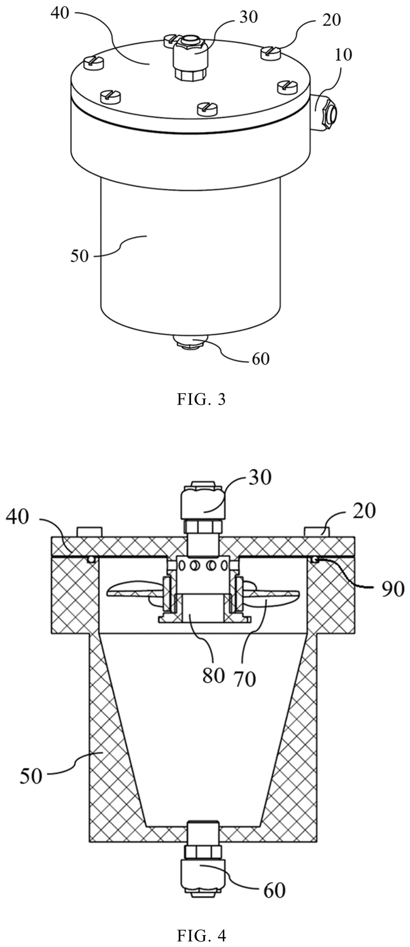

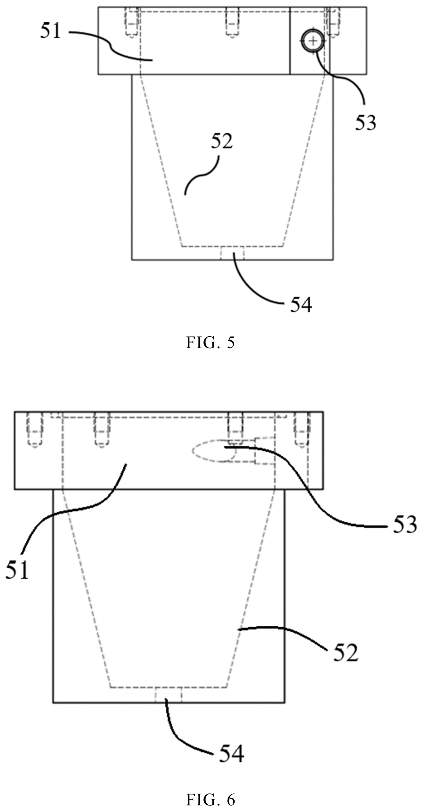

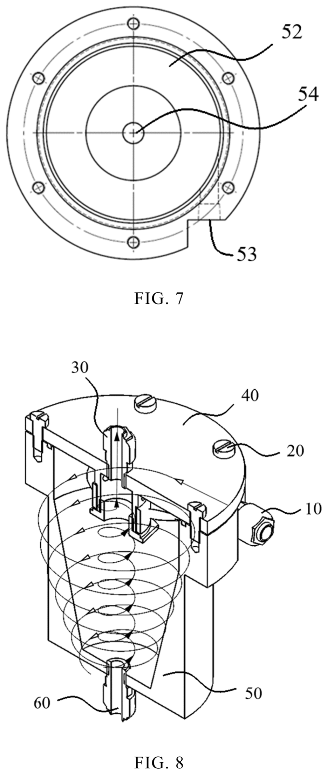

FIG. 3 is a schematic structural diagram of a liquid defoaming device according to Embodiment One of the present disclosure; FIG. 4 is a cross-sectional view of the liquid defoaming device according to the Embodiment One of the present disclosure; FIG. 5 is a schematic structural diagram of a defoaming chamber in the liquid defoaming device according to the Embodiment One of the present disclosure; FIG. 6 is a left view of FIG. 5; and FIG. 7 is a top view of FIG. 5. As shown in FIG. 3 to FIG. 7, the liquid defoaming device according to the Embodiment One of the present disclosure is applied to a semiconductor cleaning apparatus, and includes: a defoaming chamber 50 and a cover 40.

An inner wall surface of the defoaming chamber 50 is a rotating curved surface, and a radius of an inner-wall-surface lower part 52 gradually decreases from top to bottom; the defoaming chamber 50 is provided with a liquid inlet 53 and a first drain port 54, the liquid inlet 53 is disposed in an upper part of the defoaming chamber 50, a liquid inlet direction of the liquid inlet 53 is parallel with a tangential direction of an inner-wall-surface upper part 51 of the defoaming chamber 50, and the first drain port 54 is located in the middle of a bottom end of the inner wall surface.

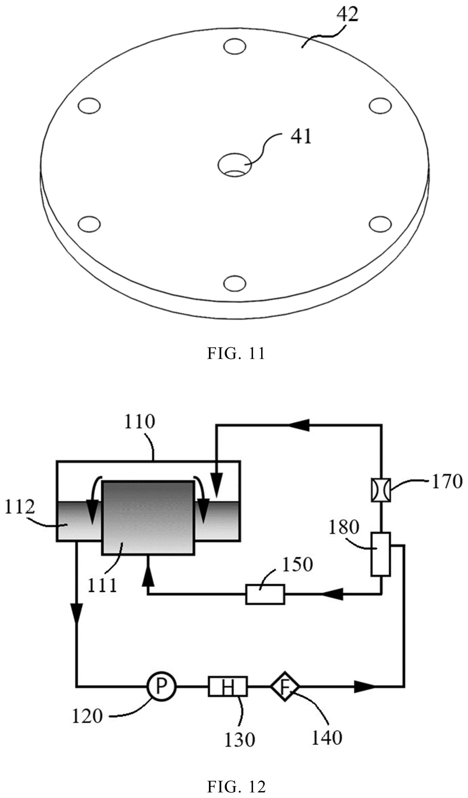

The cover 40 is disposed on the defoaming chamber 50, and is provided with a second drain port 41 (as shown in FIG. 11), and the second drain port 41 is disposed opposite to a center of a top end of the defoaming chamber 50.

In the present embodiment, the inner-wall-surface lower part 52 of the defoaming chamber 50 is in a shape of a frustum. In other implementations, the inner-wall-surface lower part 52 may be in other shapes, such as a part of an ellipsoidal surface, a part of a paraboloid, a part of an olive-shaped surface, a part of a spherical surface, and even a part of a water drop-shaped surface. The inner-wall-surface lower part 52 may be in any shape that has a radius gradually decreasing from top to bottom, and it is also acceptable even if an angled change instead of smooth transition occurs to the inner-wall-surface lower part 52.

Specifically, in the present embodiment, the first drain port 54 is, for example, equipped with a liquid outlet joint 60, and the second drain port 41 is, for example, equipped with a gas-liquid liquid outlet pipe joint 30. The liquid inlet 53 is communicated with a liquid inlet pipe 10 located outside the defoaming chamber 50.

An edge of the cover 40 may be matched with a threaded hole in a top surface of the defoaming chamber 50 through a male threaded connector 20 such as a screw or a bolt, so that the cover 40 is mounted on the defoaming chamber 50. A sealing ring 90 is disposed between the defoaming chamber 50 and the cover 40 to seal the defoaming chamber 50 and the cover 40. The sealing ring 90 is, for example, partially fixed in a mounting groove in the top surface of the defoaming chamber 50.

By disposing the liquid inlet 53 in the upper part of the defoaming chamber 50 along the direction parallel with the tangential direction of the inner-wall-surface upper part 51, when a mixed solution flows into the upper part of the defoaming chamber 50 from the liquid inlet 53, the mixed solution performs a circumferential motion along the inner-wall-surface upper part 51 instead of a linear motion along the direction parallel with the tangential direction of the inner-wall-surface upper part 51, the mixed solution is thrown to the inner wall surface of the defoaming chamber 50 under the action of centrifugal force, and the mixed solution may spirally move towards the inner-wall-surface lower part 52 along the inner-wall-surface upper part 51 once in contact with the inner wall surface. Since a density of the liquid in the mixed solution is much greater than that of the foam in the mixed solution, the liquid is more likely to concentrate towards the inner wall surface than the foam during the spiral movement, that is, a larger proportion of the liquid is thrown towards the inner wall surface, while the foam is relatively away from the inner wall surface.

When the mixed solution enters the inner-wall-surface lower part 52 having the radius gradually decreasing from top to bottom, since the mixed solution does not flow on an absolute horizontal plane, the gravitational acceleration is converted into an increase of an actual tangential velocity with the aid of the shape of the inner-wall-surface lower part 52, and an inertial centrifugal force of the mixed solution is increased as a rotation radius gradually decreases, so that a tendency of the liquid in the mixed solution to move outwards becomes more obvious. Meanwhile, as the rotation radius gradually decreases, the mixed solution may also generate a velocity component towards a center of a bottom of the inner wall surface, and finally forms a centripetal radial liquid flow under the extrusion of an outward vortex at the bottom. In addition, during the movement, the foam may gradually float upwards due to the smaller density thereof. Due to continuous injection of the mixed solution from a position close to the inner wall surface, the foam may gradually converge upwards and towards a center of the defoaming chamber 50. Therefore, the liquid falling to a bottom of the defoaming chamber 50 contains almost no foam, and may be discharged through the first drain port 54 in the middle of the bottom end. The mixed solution containing a large proportion of foam is prevented from being discharged from the first drain port 54 under the action of the original tangential velocity, and still flows in a spiral manner. Meanwhile, the mixed solution containing a large proportion of foam is confined, from the outside, by the outward vortex flowing downwards along the inner wall surface, so that the mixed solution containing a large proportion of foam flows upwards in a spiral manner, that is, forming upward inward vortex, and is finally discharged through the second drain port 41. A flow state of the mixed solution in the defoaming chamber 50 is shown in FIG. 8. In FIG. 8, the spiral line where the hollow arrows are located indicates the downward outward vortex, while the spiral line where the solid arrows are located indicates the upward inward vortex.

Thus, the liquid defoaming device can effectively separate the liquid having a high foam content in the mixed solution from the foam-free liquid in the mixed solution, and can achieve higher separation speed and higher separation efficiency compared with static gas-liquid separation or a method not adopting a chamber with a radius gradually decreasing from top to bottom.

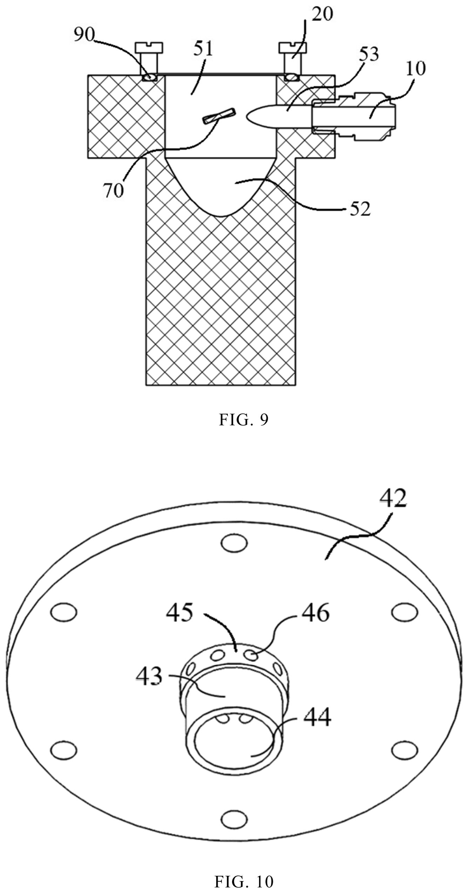

FIG. 9 provides another cross-sectional view of the liquid defoaming device according to the Embodiment One of the present disclosure, so as to clearly illustrate a case where the mixed solution entering the defoaming chamber from the liquid inlet is guided by a guide member. As shown in FIG. 4, FIG. 8, and FIG. 9, preferably, the liquid defoaming device further includes a guide member disposed opposite to the liquid inlet 53, a first surface of the guide member facing the liquid inlet 53 gradually descends along a direction (i.e., a liquid inlet direction) in which the mixed solution entering from the liquid inlet 53 flows on the first surface, and the first surface is configured to increase a downward flow velocity of the mixed solution.

In the present embodiment, the first surface is a lower surface of the guide member, and since the lower surface of the guide member is disposed obliquely, the lower surface of the guide member is also the surface of the guide member facing the liquid inlet 53. The mixed solution impacts the lower surface of the guide member first after entering the defoaming chamber 50, and is guided by the lower surface of the guide member to change a flow direction.

With the arrangement of the guide member, part of a velocity of the mixed solution entering from the liquid inlet 53 can be converted into a velocity downwards the defoaming chamber 50, so that the mixed solution has a horizontal velocity component along the direction parallel with the tangential direction of the inner-wall-surface upper part 51 and a vertical downward velocity component along a height direction of the defoaming chamber 50, which can increase the downward flow velocity of the mixed solution, accelerate separation of the inward vortex from the outward vortex, and prevent a large amount of mixed solution from being stored in the upper part of the defoaming chamber 50 for a long time, and also can disperse the foam and the liquid in the mixed solution to break an original tendency to uniform mixing of the foam and the liquid, thereby improving separation efficiency.

As shown in FIG. 4, FIG. 8, and FIG. 9, preferably, an acute angle between the first surface and a horizontal direction gradually increases along the direction in which the mixed solution flows on the first surface.

Specifically, the first surface may be a curved surface having arc surfaces at all positions; alternatively, the first surface may be a folded-line surface including a plurality of planes, with fillet transition or folded-angle transition adopted between the planes.

With the acute angle between the first surface and the horizontal direction gradually increasing along the direction in which the mixed solution flows on the first surface, the tangential velocity of the mixed solution along the inner-wall-surface upper part 51 can be gradually converted into the vertical downward velocity component, so that a loss of velocity in a process of changing an orientation of the velocity of the mixed solution can be reduced, which ensures the flow velocity of the mixed solution in the defoaming chamber 50 for foam-liquid separation.

In another implementation, the first surface of the guide member may be an obliquely disposed plane, which can also perform the function to convert part of the horizontal component of the flow velocity of the mixed solution into the vertical velocity component.

As shown in FIG. 4, preferably, the guide member is a rotary impeller 70, and the rotary impeller 70 performs a circumferential motion relative to the cover 40 and is axially fixed to the cover 40.

In the present embodiment, the rotatory impeller as the guide member may include a plurality of guide blades, a lower surface of each guide blade is the first surface, and all the lower surfaces of the different guide blades may be impacted by the mixed solution entering from the liquid inlet 53 and guide the mixed solution when the liquid defoaming device is in operation. For each guide blade in the rotary impeller, an included angle between a root and the horizontal direction is, for example, 60°, and an included angle between a free end and the horizontal direction is, for example, 30°.

By adopting the rotary impeller 70 as the guide member, when being impacted by the mixed solution entering from the liquid inlet 53, the guide member can rotate along the liquid inlet direction, that is, rotating along a circumferential direction of the inner-wall-surface upper part, so that the direct impact of the liquid flow on the guide member can be reduced, and correspondingly, a blocking effect of the guide member on the liquid flow can also be reduced, and a loss of liquid energy in the flowing process can be reduced. In addition, with the liquid flow impacting the different guide blades, a case where a fixed region of one guide blade is continuously impacted for a long time can be avoided, which facilitates prolonging a service life of the guide member.

In another implementation, the guide member may be fixed, for example, one or more guide blades are fixed, and a lower surface of each guide blade gradually descends along the liquid inlet direction, and may be plane or a curved surface, so that the tangential momentum of the mixed solution entering from the liquid inlet 53 can be converted into the vertical downward momentum, thereby accelerating the liquid flow.

FIG. 10 is a schematic structural diagram of the cover in the liquid defoaming device according to the Embodiment One of the present disclosure; and FIG. 11 is a schematic structural diagram of the cover in the liquid defoaming device according to the Embodiment One of the present disclosure from another view. As shown in FIG. 4, FIG. 10, and FIG. 11, preferably, the cover 40 includes: a cover body 42 and an impeller mounting part 43.

The impeller mounting part 43 is fixedly connected to a surface of the cover body 42 facing an interior of the defoaming chamber 50; and an impeller fixing member 80 is fixedly connected to a bottom of the impeller mounting part 43, and is configured to axially fix the rotary impeller 70.

The rotatory impeller 70 and/or the impeller mounting part 43 may be made of polytetrafluoroethylene which is not only chemically stable but also has a self-lubricating property, which facilitates reducing the friction between the impeller mounting part 43 and the rotatory impeller 70 and obviates the need to dispose a rotating bearing specifically for the mounting of the rotatory impeller 70.

By fixedly connecting the impeller fixing member 80 to the bottom of the impeller mounting part 43, the rotary impeller 70 can be prevented from moving in an axial direction of the impeller mounting part 43.

In another implementation, a vertical shaft may be disposed at a top of the inner wall surface of the defoaming chamber 50. Specifically, the vertical shaft may be fixedly connected to the top of the inner wall surface through one or more cantilever beams, and the rotary impeller 70 is rotatably mounted on the vertical shaft. The vertical shaft may be solid or hollow as long as the rotary impeller 70 can be driven to rotate by the mixed solution entering from the liquid inlet 53 when the mixed solution flows to the rotary impeller 70. Therefore, the rotary impeller 70 performing a circumferential motion relative to the cover 40 and being axially fixed to the cover 40 is not limited to connecting the rotary impeller 70 to the cover 40 with a bearing or a sleeve-type part, and just indicates a relative motion relationship between the rotary impeller 70 and the cover 40, and the rotary impeller 70 may be rotatably mounted anywhere as long as the rotary impeller 70 performs a circumferential motion relative to the cover 40 and is axially fixed to the cover 40.

As shown in FIG. 4 and FIG. 10, preferably, the impeller mounting part 43 is provided with a sleeve part, a bottom of the sleeve part is provided an internal thread 44, the impeller fixing member 80 is provided with an external thread, and the impeller fixing member 80 is fixedly connected to the sleeve part through the external thread and the internal thread 44 matched with each other.

Specifically, in the present embodiment, the impeller fixing member 80 is a hollow cylinder, and the impeller fixing member 80 is further provided with a flange part in addition to the part provided with the external thread. After the impeller fixing member 80 is screwed to the sleeve part, the flange part of the impeller fixing member 80 may axially limit the rotary impeller 70.

By disposing the thread on an inner side of the sleeve part, the space of an outer surface of the sleeve part can be released, so that the sleeve part can have a greater length to be matched with the rotary impeller 70, so as to elongate a rotatable connection support for the rotary impeller 70 and improve stability of the motion of the rotary impeller 70.

In another implementation, as shown in FIG. 10 and FIG. 11, the defoaming device further includes a drain pipe 45 located at the top of the space inside the defoaming chamber 50 and communicated with the second drain port 41. On this basis, the impeller mounting part 43 may be disposed with the drain pipe 45 in a coaxial way or a non-coaxial way, for example, the impeller mounting part 43 may be a hollow cylinder or a solid shaft. That is, in addition to the second drain port 41 and the drain pipe 45, the impeller mounting part 43 is separately disposed on the cover body 42 for the mounting of the rotary impeller 70, so that the rotary impeller 70 can rotate under the action of the mixed solution entering from the liquid inlet 53, change the flow direction of the mixed solution, and produce the effects of accelerating the flow of the mixed solution and dispersing the foam and the liquid in the mixed solution.

In another implementation, the impeller fixing member 80 may be a positioning pin penetrating through the impeller mounting part 43 in a radial direction, or an annular outer flange having a one-piece structure or a multi-section structure and disposed on an outer side of the bottom of the impeller mounting part 43, a lower surface of the annular outer flange is a conical surface, and the impeller mounting part 43 when being mounted may push the annular outer flange to be mounted in place.

As shown in FIG. 10 and FIG. 11, preferably, the defoaming device further includes the drain pipe 45 located at the top of the space inside the defoaming chamber 50 and communicated with the second drain port 41, and a top of the drain pipe 45 is provided with radial through holes 46 penetrating through the drain pipe 45 along a thickness direction of the drain pipe 45.

Specifically, in the present embodiment, the drain pipe 45 is fixedly connected to the surface of the cover body 42 facing the interior of the defoaming chamber 50. More specifically, the drain pipe 45 may be coaxially disposed with the second drain port 41, and after the mixed solution flowing upwards in the form of inward vortex enters the drain pipe 45, the mixed solution may directly enter the second drain port 41. The drain pipe 45 and the impeller mounting part 43 may be disposed as one piece.

By disposing the radial through holes 46 penetrating through the drain pipe 45 along the thickness direction thereof at the top of the drain pipe 45, the liquid in the mixed solution having a high foam content and moving upwards can be discharged through the radial through holes 46, so that the mixed solution discharged from the second drain port 41 has the higher foam content.

As shown in FIG. 4 to FIG. 8, preferably, the inner-wall-surface upper part 51 of the defoaming chamber 50 is a cylindrical surface.

By setting the inner wall surface of the defoaming chamber 50 as the cylindrical surface, the upper part of the defoaming chamber 50 can provide a relatively large cavity space to counteract pulses generated by the diaphragm pump, thereby producing a flow-stabilization and buffering effect.

### Embodiment Two

Embodiment Two further provides a cleaning apparatus, including a circulation pump 120, a heater 130, a filter 140, and the liquid defoaming device 180 provided in the Embodiment One, which are sequentially communicated.

By disposing the liquid defoaming device 180 in the cleaning apparatus, the cleaning apparatus has all the advantages of the liquid defoaming device 180, but those advantages will not be described here
FIG. 12 is a schematic structural diagram of the cleaning apparatus according to an implementation of the Embodiment Two of the present disclosure. As shown in FIG. 12, preferably, the cleaning apparatus further includes a process tank 110 including an inner tank 111 and an outer tank 112 outside the inner tank 111, an inlet of the circulation pump 120 is communicated with an outlet of the outer tank 112, an outlet of the filter 140 is communicated with the liquid inlet 53 of the liquid defoaming device 180, the first drain port 54 of the liquid defoaming device 180 is communicated with an inlet of the inner tank 111 through a flowmeter 150, and the second drain port 41 of the liquid defoaming device 180 is communicated with an inlet of the outer tank 112 through a throttling element 170.

A chemical solution enters the circulation pump 120 after flowing out of the outer tank 112 and flows through the heater 130, the filter 140, and the liquid defoaming device 180, and a mixed solution enters the liquid defoaming device 180 from the liquid inlet 53, flows out from the first drain port 54 at the bottom of the liquid defoaming device 180, enters the inner tank 111 through the flowmeter 150, and then overflows from the inner tank 111 to the outer tank 112, thereby completing a cycle. The mixed solution having a high foam content and discharged from the second drain port 41 at the top of the liquid defoaming device 180 flows back to the outer tank 112 through the throttling element 170.

By enabling the liquid flowing out from the first drain port 54 of the liquid defoaming device 180 to flow through the flowmeter 150, a liquid flow rate measured by the flowmeter 150 is relatively close to a real flow rate, accuracy of the flow measurement can be improved, and control precision can be improved.

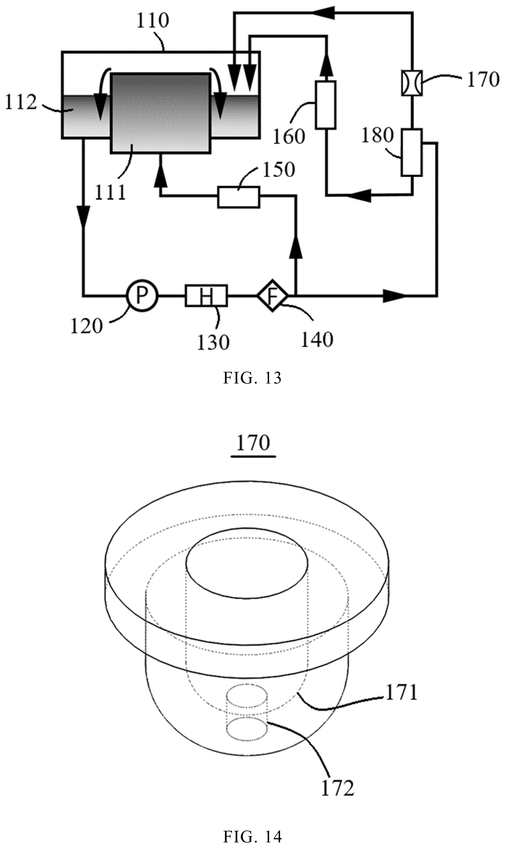

FIG. 13 is a schematic structural diagram of the cleaning apparatus according to another implementation of the Embodiment Two of the present disclosure. As shown in FIG. 13, preferably, the cleaning apparatus further includes a process tank 110 including an inner tank 111 and an outer tank 112 outside the inner tank 111, an inlet of the circulation pump 120 is communicated with an outlet of the outer tank 112, an outlet of the filter 140 is communicated with the liquid inlet 53 of the liquid defoaming device 180 and an inlet of a flowmeter 150, an outlet of the flowmeter 150 is communicated with an inlet of the inner tank 111, the first drain port 54 of the liquid defoaming device 180 is communicated with an inlet of the outer tank 112 through a concentration meter 160, and the second drain port 41 of the liquid defoaming device 180 is communicated with the inlet of the outer tank 112 through a throttling element 170.

A chemical solution enters the circulation pump 120 after flowing out of the outer tank 112, flows through the heater 130, the filter 140, and the flowmeter 150, flows into the inner tank 111, and overflows from the inner tank 111 to the outer tank 112, thereby completing a cycle. In order to detect a concentration, a branch is provided after the filter 140 to enable a mixed solution to enter the liquid defoaming device 180 from the liquid inlet 53, a foam-free liquid flowing out from the first drain port 54 at the bottom of the liquid defoaming device 180 enters the concentration meter 160 for detection, and the detected liquid flows back to the outer tank 112; and the mixed solution having a high foam content and discharged from the second drain port 41 at the top of the liquid defoaming device 180 flows back to the outer tank 112 through the throttling element 170.

By enabling the liquid flowing out from the first drain port 54 of the liquid defoaming device 180 to flow through the concentration meter 160, a concentration measured by the concentration meter 160 is relatively close to a real concentration, accuracy of the concentration measurement can be improved, and control precision can be improved.

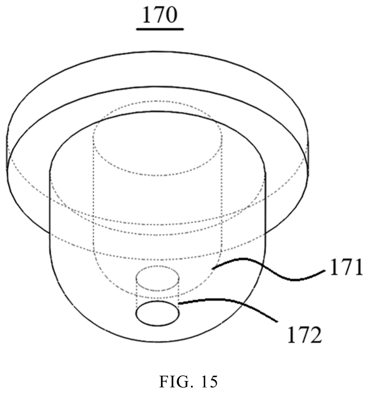

FIG. 14 is a schematic structural diagram of the throttling element in the cleaning apparatus according to an implementation manner of the Embodiment Two of the present disclosure; and FIG. 15 is a schematic structural diagram of the throttling element of FIG. 14 from another view. As shown in FIG. 14 and FIG. 15, preferably, the throttling element 170 includes a throttling cavity 171, a bottom of an inner wall surface of the throttling cavity 171 is a hemispherical surface, and a throttle hole 172 is provided at a bottom of the throttling cavity 171.

By disposing the throttling element 170 having the throttle hole 172, under the action of surface tension, the smaller the diameter of the throttle hole 172, the poor the capability of the liquid to pass through the throttle hole 172, the larger the proportion of gas in a gas-liquid mixture discharged from the throttle hole 172. The diameter of the throttle hole 172 is not desired to be too small for ensuring a gas discharge rate of the liquid defoaming device 180. Therefore, by selecting an appropriate diameter for the throttle hole 172, a gas-liquid ratio and a flow rate of the mixed solution discharged from the second drain port 41 can be effectively controlled, and reflux utilization of the liquid in the circulation pipelines can be improved.

Preferably, the throttling element 170 is a needle valve or a capillary tube.

With the above arrangement, the gas-liquid ratio and the flow rate of the discharged mixed solution can be effectively controlled, the reflux utilization of the liquid in the circulation pipelines can be improved, the complex design caused by the introduction of devices such as pneumatic valves and sensors can be avoided, and easy maintenance can be realized.

Although the present disclosure is disclosed as above, the present disclosure is not limited to the above. Various changes and improvements can be made by those of ordinary skill in the art without departing from the spirit and scope of the present disclosure, so that the scope of the present disclosure is the scope of the appended claims.

Finally, it should be noted that the relational terms such as "first" and "second" herein are just used to distinguish one entity or operation from another entity or operation, and do not necessarily require or imply that such relationship or order actually exists between the entities or operations. Moreover, the term "include" or any other variation thereof is intended to indicate a non-exclusive inclusion, so that a process, method, article, or device, which includes a series of elements, does not only include those listed elements but also include other elements that are not explicitly listed, or the elements inherent in such process, method, article, or device. If there are no more limitations, limiting an element by "including a..." does not exclude the existence of other identical elements in the process, method, article, or device which includes the element.

In the above embodiments, the descriptions using the terms such as "up" and "down" is based on the drawings.

The above description of the embodiments of the present disclosure can enable those of ordinary skill in the art to implement or use the present disclosure. Various modifications to these embodiments are apparent to those of ordinary skill in the art, and the general principle defined herein may be implemented in other embodiments without departing from the spirit or scope of the present disclosure.

Thus, the present disclosure is not limited to the embodiments described herein, but falls in the widest scope consistent with the principle and novel features disclosed herein.

## Claims

1. A liquid defoaming device applied to a semiconductor cleaning apparatus, comprising:
a defoaming chamber, an inner wall surface of the defoaming chamber being a rotating curved surface, and a radius of an inner-wall-surface lower part gradually decreasing from top to bottom; the defoaming chamber being provided with a liquid inlet and a first drain port, the liquid inlet being disposed in an upper part of the defoaming chamber, a liquid inlet direction of the liquid inlet being parallel with a tangential direction of an inner-wall-surface upper part of the defoaming chamber, and the first drain port being located in the middle of a bottom end of the inner wall surface; and
a cover, the cover being disposed on the defoaming chamber and provided with a second drain port, and the second drain port being disposed opposite to a center of a top end of the defoaming chamber.

2. The liquid defoaming device of claim 1, further comprising a guide member, which is disposed opposite to the liquid inlet, wherein a first surface of the guide member facing the liquid inlet gradually descends along a direction in which a mixed solution entering from the liquid inlet flows on the first surface, and the first surface is configured to increase a downward flow velocity of the mixed solution.

3. The liquid defoaming device of claim 2, wherein an acute angle between the first surface and a horizontal direction gradually increases along the direction in which the mixed solution flows on the first surface.

4. The liquid defoaming device of claim 2, wherein the guide member is a rotary impeller, and the rotary impeller performs a circumferential motion relative to the cover and is axially fixed to the cover.

5. The liquid defoaming device of claim 4, wherein the cover comprises:
a cover body; and
an impeller mounting part, which is fixedly connected to a surface of the cover body facing an interior of the defoaming chamber; and an impeller fixing member being fixedly connected to a bottom of the impeller mounting part and configured to axially fix the rotary impeller.

6. The liquid defoaming device of claim 5, wherein the impeller mounting part is provided with a sleeve part, a bottom of the sleeve part is provided an internal thread, the impeller fixing member is provided with an external thread, and the impeller fixing member is fixedly connected to the sleeve part through the external thread and the internal thread matched with each other.

7. The liquid defoaming device of any one of claims 1 to 6, further comprising:
a drain pipe, which is located at a top of a space inside the defoaming chamber and communicated with the second drain port, and has a top provided with radial through holes penetrating through the drain pipe along a thickness direction of the drain pipe.

8. The liquid defoaming device of any one of claims 1 to 6, wherein the inner-wall-surface upper part of the defoaming chamber is a cylindrical surface.

9. A cleaning apparatus, comprising a circulation pump, a heater, a filter, and the liquid defoaming device of any one of claims 1 to 8, which are sequentially communicated.

10. The cleaning apparatus of claim 9, further comprising a process tank, wherein the process tank comprises an inner tank and an outer tank outside the inner tank, an inlet of the circulation pump is communicated with an outlet of the outer tank, an outlet of the filter is communicated with the liquid inlet of the liquid defoaming device, the first drain port of the liquid defoaming device is communicated with an inlet of the inner tank through a flowmeter, and the second drain port of the liquid defoaming device is communicated with an inlet of the outer tank through a throttling element.

11. The cleaning apparatus of claim 9, further comprising a process tank, wherein the process tank comprises an inner tank and an outer tank outside the inner tank, an inlet of the circulation pump is communicated with an outlet of the outer tank, an outlet of the filter is communicated with the liquid inlet of the liquid defoaming device and an inlet of a flowmeter, an outlet of the flowmeter is communicated with an inlet of the inner tank, the first drain port of the liquid defoaming device is communicated with an inlet of the outer tank through a concentration meter, and the second drain port of the liquid defoaming device is communicated with the inlet of the outer tank through a throttling element.

12. The cleaning apparatus of claim 10 or 11, wherein the throttling element comprises a throttling cavity, a bottom of an inner wall surface of the throttling cavity is a hemispherical surface, and a throttle hole is provided at a bottom of the throttling cavity.

13. The cleaning apparatus of claim 10 or 11, wherein the throttling element is a needle valve or a capillary tube.
